# EUROPÄISCHE PATENTSCHRIFT

(11) **EP 2 359 398 B1**
(45) Veröffentlichungstag und Bekanntmachung des Hinweises auf die Patenterteilung: **10.05.2017**
(21) Anmeldenummer: 09749087.4
(22) Anmeldetag: 03.11.2009
(51) Int. Cl.: H01L 21/68, H01L 21/00

(54) **VERFAHREN ZUM ABLÖSEN UND ENTNEHMEN EINES HALBLEITERCHIPS VON EINER FOLIE**
METHOD FOR DETACHING AND REMOVING A SEMICONDUCTOR CHIP FROM A TAPE
PROCÉDÉ POUR DÉTACHER ET PRÉLEVER UNE PUCE DE SEMI-CONDUCTEUR SUR UN FILM

(30) Priorität: 12.11.2008 US 113761 P
(43) Veröffentlichungstag der Anmeldung: 24.08.2011
(73) Patentinhaber: Besi Switzerland AG, CH-6330 Cham (CH)
(72) Erfinder: BEHLER, Stefan, CH-6312 Steinhausen (CH)
(74) Vertreter: Falk, Urs
(86) Internationale Anmeldenummer: PCT/EP2009/064535
(87) Internationale Veröffentlichungsnummer: WO 2010/054957

(56) Entgegenhaltungen:
- EP-A- 1 424 722
- US-A1- 2003 101 576
- US-A1- 2005 224 965
- US-A1- 2006 237 142
- US-B1- 6 561 743

## Beschreibung

### Technisches Gebiet

Die Erfindung betrifft ein mit mechanischen Mitteln unterstütztes Verfahren zum Ablösen und Entnehmen eines Halbleiterchips von einer Folie.

### Hintergrund der Erfindung

Die Halbleiterchips werden typischerweise auf einer von einem Rahmen gehaltenen Folie, in der Fachwelt auch als Tape bekannt, zur Abarbeitung auf einer Halbleiter-Montageeinrichtung bereitgestellt. Die Halbleiterchips haften auf der Folie. Der Rahmen mit der Folie wird von einem verschiebbaren Wafertisch aufgenommen. Taktweise werden der Wafertisch verschoben, um einen Halbleiterchip nach dem anderen an einem Ort bereitzustellen, und dann der bereitgestellte Halbleiterchip von einem Chipgreifer aufgenommen und auf einem Substrat plaziert. Die Entnahme des bereitgestellten Halbleiterchips von der Folie wird von einem unterhalb der Folie angeordneten Chip-Auswerfer (in der Fachwelt bekannt als Die-Ejector) unterstützt. Der Chip-Auswerfer ist ein Tisch mit einer Auflagefläche, auf der die Folie aufliegt. Der Tisch enthält eine Vielzahl von Löchern, um die Folie während des Ablöseprozesses des Halbleiterchips mittels Vakuum festzuhalten.

In vielen Fällen unterstützt eine oder mehrere im Chip-Auswerfer angeordnete Nadel das Ablösen des Halbleiterchips von der Folie. Nadelunterstützte Verfahren sind aus einer Vielzahl von Patenten bekannt, beispielsweise aus US 20040105750 oder US 7265035. Bei der US 2008086874 enthält der Chip-Auswerfer einen Block mit einer Vielzahl von Stäben, die ein flaches Ende aufweisen, und einen zweiten Block mit einer Vielzahl von Nadeln, wobei die Nadeln zwischen den Stäben angeordnet sind und wobei die Fläche des flachen Endes jedes Stabes ein mehrfaches des Querschnitts einer Nadel beträgt. Zum Ablösen des Halbleiterchips wird zuerst der Block mit den Stäben angehoben und dann wird der Block mit den Nadeln angehoben, bis die Nadeln über die Stäbe hervorstehen.

Aus der WO 2005117072 ist ein Chip-Auswerfer mit stützenden Strukturen bekannt, auf denen die Folie während des ganzen Ablöseprozesses aufliegt. Die stützenden Strukturen sind umgeben von Stäben mit einem flachen Ende, die in Richtung zum Halbleiterchip wie auch in entgegengesetzter Richtung verschiebbar sind. Die stützenden Strukturen und die Stäbe können auch durch eine Vielzahl von matrixartig angeordneten einzelnen Stösseln gebildet sein.

Aus der US 20050059205 ist ein Chip-Auswerfer bekannt, der mehrere nebeneinander liegende Platten aufweist, die zum Ablösen des Halbleiterchips entweder gemeinsam angehoben und dann von aussen nach innen sequenziell abgesenkt werden oder von aussen nach innen sequenziell angehoben werden, um eine pyramidenförmige, über die Stützebene hinausragende Erhöhung zu bilden.

Bekannt sind auch verschiedene Verfahren, bei denen der Halbleiterchip ohne Mithilfe einer Nadel von der Folie abgelöst wird: Bei der US 4921564 wird die Folie unterhalb des Halbleiterchips an vielen einzelnen Stellen mit Vakuum beaufschlagt, um die Folie an diesen Stellen vom Halbleiterchip abzuziehen. Bei der US 20040038498 ist dies ebenfalls der Fall, der Chipgreifer holt hier den Halbleiterchip erst dann, wenn der Ablöseprozess abgeschlossen ist, d.h. wenn der Chip-Auswerfer den Ablöseprozess nicht mehr weiterführen kann. Dieses Verfahren eignet sich deshalb nicht für extrem dünne Halbleiterchips, da diese zerbrechen würden. Bei der EP 1496422 wird die Folie mittels eines Stempels ohne Mithilfe des Chipgreifers vollständig vom Halbleiterchip gelöst. Dieses Verfahren eignet sich auch nicht für extrem dünne Halbleiterchips, da sich diese verbiegen und/oder zusammenrollen würden. Bei der US 2002129899 und der US 7238593 wird die Folie über eine Kante des Chip-Auswerfers gezogen und dabei abgelöst. Bei der US 6561743 wird die Folie zunächst in einem Randbereich des Halbleiterchips mittels Vakuum abgezogen und dann relativ zu dem vom Chipgreifer festgehaltenen Halbleiterchip verschoben, wobei der Halbleiterchip von der Folie abgelöst wird.

Das Ablösen und Entnehmen eines Halbleiterchips von der Folie wird in der Fachwelt als Pick-Prozess bezeichnet. Ein nadelunterstützter Standard Pick-Prozess umfasst die folgenden Schritte:
a) Verschieben des Wafertisches, um den nächsten aufzunehmenden Halbleiterchip bereitzustellen;
b) Festhalten der Folie auf dem Chip-Auswerfer mittels Vakuum;
c) Absenken des Chipgreifers, bis er die Oberfläche des Halbleiterchips berührt, und Beaufschlagen des Chipgreifers mit Vakuum, um den Halbleiterchip festzuhalten;
d) Anheben der Nadeln auf eine vorbestimmte Höhe, wobei die Nadeln den Halbleiterchip anheben und die Folie sich zum Teil vom Halbleiterchip löst;
e) Wegfahren des Chipgreifers, wobei sich der Halbleiterchip komplett von der Folie sowie von den Nadeln ablöst.

Das Ablösen und Entnehmen des Halbleiterchips von der Folie kann nur dann gelingen, wenn die nach dem Schritt d) noch verbleibende Klebekraft der Folie kleiner ist als die Vakuum-Saugkraft des Chipgreifers. Andernfalls treten sogenannte Pickfehler auf: Der Halbleiterchip kann nicht aufgenommen werden, sehr dünne Halbleiterchips werden beschädigt oder zerbrechen.

Der Halbleiterchip wird entweder mittels eines Klebstoffes, der vorgängig auf das Substrat aufgebracht wurde, oder mittels eines auf seiner Rückseite angebrachten Klebstofffilms, eines sogenannten "Die Attach Films", beim Bonden mit dem Substrat verklebt. Im letzteren Fall muss der Halbleiterchip mit dem Klebstofffilm von der Folie getrennt werden. Das Substrat wird auf eine über der Raumtemperatur liegende Temperatur aufgeheizt, um beim Bonden eine dauerhafte Klebeverbindung zwischen dem Halbleiterchip und dem Substrat herzustellen. Infolge seines Kontaktes mit dem Substrat schmilzt der Klebstofffilm und klebt den Halbleiterchip fest. Durch diesen einige Sekunden dauernden Klebeprozess heizt sich der Chipgreifer auf. Beim nächsten Pick-Prozess tritt dadurch beim nächsten aufzunehmenden Halbleiterchip eine unerwünschte Erwärmung des Klebstofffilms bereits während des Ablösevorgangs auf. Dabei nimmt die Klebekraft zwischen der Folie und dem Klebstofffilm zu, was zu den oben erwähnten Pickfehlern führen kann.

Im folgenden wird unter dem Begriff Halbleiterchip auch ein Halbleiterchip verstanden, dessen Rückseite mit einem Klebstofffilm beschichtet ist.

### Kurze Beschreibung der Erfindung

Es wäre daher wünschenswert, ein Verfahren zur Verfügung zu haben, welches es gestattet, die Halbleiterchips, insbesondere auch sehr dünne Halbleiterchips mit einer Dicke von weniger als 50 µm, in möglichst kurzer Zeit von der Folie abzuheben, so dass die während der kurzen Kontakt-Zeit durch den Chipgreifer bewirkte Erwärmung des Halbleiterchips die Klebeverbindung zwischen der Folie und dem Halbleiterchip nur unwesentlich verstärkt.

Die Erfindung geht von der Erkenntnis aus, dass dies dann zu erreichen ist, wenn die Haftung zwischen dem Halbleiterchip (bzw. dem Klebstofffilm) und der Folie soweit verkleinert wird, dass selbst bei einem schnellen Ablösen des Halbleiterchips von der Folie die dabei aufgrund der Klebeverbindung entstehenden Kräfte unkritisch bleiben. Dabei ist zu beachten, dass ein Klebstofffilm, dessen Klebeverbindung von vorneherein schwach ist, nicht zur Anwendung kommen kann, da hierbei die Gefahr besteht, dass sich die Halbleiterchips bereits bei der Vereinzelung des Wafers in die einzelnen Halbleiterchips (beim Sägen) oder beim Transport des zersägten Wafers unkontrolliert von der Folie ablösen.

Dementsprechend wird erfindungsgemäss das Verfahren nach Anspruch 1 angegeben. Die Erfindung schlägt deshalb vor, in einer ersten Phase eine Abschwächung der Klebeverbindung durch teilweises Loslösen der Folie vom Halbleiterchip mit mechanischen Mitteln zu bewerkstelligen, bevor der Chipgreifer in Kontakt mit dem Halbleiterchip ist und den Halbleiterchip festhält, in einer zweiten Phase den Chipgreifer in Kontakt mit dem Halbleiterchip zu bringen und den Halbleiterchip festzuhalten und dann die Folie mit Unterstützung des Chipgreifers weiter vom Halbleiterchip abzulösen, und in einer dritten Phase den Chipgreifer mit dem Halbleiterchip wegzufahren.

Das Verfahren zum Ablösen und Entnehmen eines Halbleiterchips von einer Folie wird von einem Chip-Auswerfer unterstützt. Der Chip-Auswerfer weist eine Auflagefläche auf, auf der die Folie aufliegt. Das erfindungsgemässe Verfahren umfasst eine erste Phase ohne Beteiligung des Chipgreifers mit den Schritten:
Bereitstellen des nächsten aufzunehmenden Halbleiterchips auf der Auflagefläche des Chip-Auswerfers;
Beaufschlagen des Chip-Auswerfers mit Vakuum, um die Folie auf dem Chip-Auswerfer festzuhalten;
Teilweises Ablösen der Folie vom bereitgestellten Halbleiterchip mit mechanischen Mitteln; und Aufnehmen eines Bildes des Halbleiterchips und Bestimmen seiner Lage bzw. der Abweichung seiner Ist-Lage von seiner Soll-Lage;
Das erfindungsgemässe Verfahren umfasst eine zweite Phase mit den Schritten:
Absenken des Chipgreifers, bis der Chipgreifer die Oberfläche des Halbleiterchips berührt, Beaufschlagen des Chipgreifers mit Vakuum, um den Halbleiterchip festzuhalten;
Weiteres Ablösen der Folie vom bereitgestellten Halbleiterchip; und eine dritte Phase mit dem Schritt:
   Anheben und Wegfahren des Chipgreifers.

Das erfindungsgemässe Verfahren wurde insbesondere für sehr dünne Halbleiterchips mit Dicken unterhalb von 50 µm entwickelt. In der ersten Phase wird die Folie teilweise abgelöst, d.h. die Folie berührt die Unterseite des Halbleiterchips auf einem gewissen Anteil der Fläche der Unterseite nicht mehr. Am Ende der ersten Phase wird der Halbleiterchip von der Folie noch so weit gehalten, dass er erstens höchstens soweit verbogen oder gekrümmt ist, dass die Kamera ein auswertbares Bild vom Halbleiterchip aufnehmen kann, und zweitens vom Chipgreifer noch nicht ohne weitere Unterstützung des Chip Auswerfers von der Folie abgehoben werden kann, ohne dass der Halbleiterchip beschädigt oder zerstört würde. In der zweiten Phase wird die Folie weiter abgelöst, d.h. der Anteil der Fläche der Unterseite, an dem die Folie die Unterseite nicht mehr berührt, wird vergrössert. Weil der Chipgreifer den Halbleiterchip bereits festhält, verbiegt sich der Halbleiterchip in dieser Phase nicht. Am Ende der zweiten Phase ist die Folie entweder vollständig vom Halbleiterchip abgelöst oder sie berührt den Halbleiterchip nur noch auf einem kleinen Anteil der Fläche der Unterseite, der so klein ist, dass der Chipgreifer in der dritten Phase angehoben werden und wegfahren kann, wobei er den Halbleiterchip ohne Gefahr einer Beschädigung mitnimmt.

Das besagte teilweise Ablösen des Halbleiterchips von der Folie in der ersten Phase erfolgt bevorzugt durch Verschieben eines Schlittens derart, dass sich in der Auflagefläche des Chip-Auswerfers unterhalb einer Kante des bereitgestellten Halbleiterchips ein Spalt bildet, wobei das im Spalt herrschende Vakuum die Folie in den Spalt zieht und vom Halbleiterchip ablöst. Das weitere Ablösen in der zweiten Phase erfolgt durch weitere Verbreiterung des Spalts.

Das Ablösen des Halbleiterchips von der Folie kann auch mit Nadeln unterstützt werden, die senkrecht oder schräg zur Auflagefläche verschiebbar sind. Die Distanz, um die die Spitzen der Nadeln über die Auflagefläche hinausragen, wird dabei als Höhe bezeichnet. Das besagte teilweise Ablösen der Folie vom bereitgestellten Halbleiterchip in der ersten Phase erfolgt in diesem Fall durch die Schritte:
Anheben der Nadeln auf eine vorbestimmte Höhe z₁, so dass die Nadeln über die Auflagefläche hinausragen; und
Absenken der Nadeln auf eine vorbestimmte Höhe z₂, die kleiner ist als die Höhe z₁.

Die Abschwächung der Klebeverbindung kann aber auch - allein oder unterstützend - durch Kühlen der Folie von unten mittels eines Fluids, z.B. eines kalten Gases oder einer Kühlflüssigkeit, erfolgen.

### Beschreibung der Figuren

Nachfolgend werden Ausführungsbeispiele der Erfindung anhand der Zeichnung näher erläutert. Die Darstellung der Figuren ist schematisch und nicht massstäblich.
- Fig. 1a - g: zeigen verschiedene Momentaufnahmen während des Pick-Prozesses gemäss einem ersten erfindungsgemässen Ausführungsbeispiel,
- Fig. 2a - f: zeigen verschiedene Momentaufnahmen während des Pick-Prozesses gemäss einem zweiten erfindungsgemässen Ausführungsbeispiel, und
- Fig. 3: einen für das zweite Ausführungsbeispiel geeigneten Chip-Auswerfer in Aufsicht.

### Detaillierte Beschreibung der Erfindung

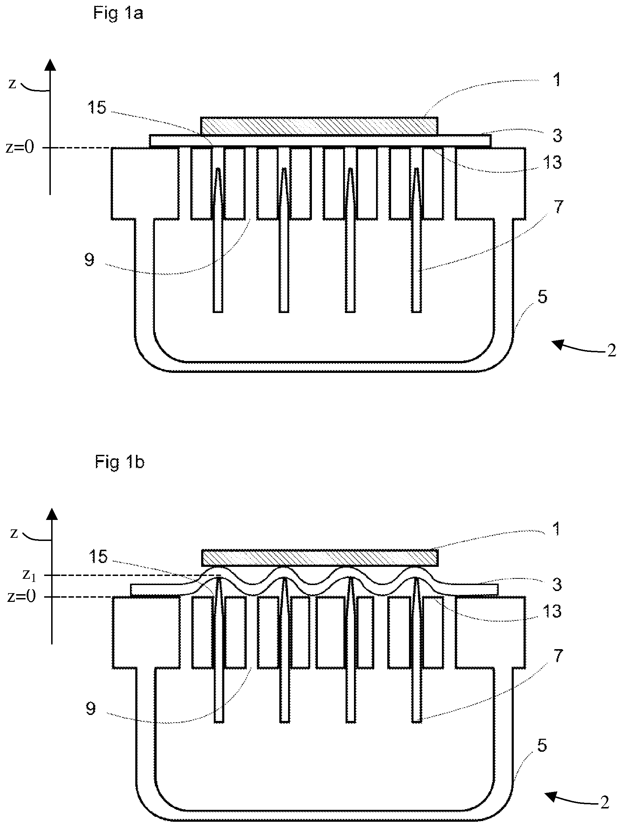

Die Fig. 1a - g zeigen die am Ablösen und Entnehmen eines Halbleiterchips 1 von einer Folie 3 beteiligten Teile eines Montageautomaten, nämlich einen Chip-Auswerfer 2 und einen Chipgreifer 11, sowie die Folie 3 und den Halbleiterchip 1 zu aufeinanderfolgenden Zeitpunkten während des erfindungsgemässen Pick-Prozesses gemäss einem ersten Ausführungsbeispiel. Die beteiligten Teile sind vereinfacht und nur insoweit dargestellt, als dies für das Verständnis des Pick-Prozesses nötig ist. Der Chip-Auswerfer 2 umfasst eine mit Vakuum beaufschlagbare Kammer 5 mit einem auswechselbaren Deckel mit einer Auflagefläche 13, auf der die Folie 3 aufliegt. Der Deckel enthält eine Vielzahl von Löchern 9 und 15. Der Durchmesser der Löcher 9 ist bevorzugt nur so gross, dass die Folie 3 nicht in die Löcher 9 hineingezogen werden kann, d.h. die Löcher 9 dienen im wesentlichen nur dazu, die Folie 3 festzuhalten. In den Löchern 15 sind Nadeln 7 angeordnet, die üblicherweise senkrecht oder schräg zur Auflagefläche 13 des Deckels verschiebbar sind. Die Richtung, in der die Nadeln 7 verschiebbar sind, ist als z-Richtung bezeichnet, wobei die Auflagefläche 13 des Deckels den Nullpunkt z = 0 definiert. Als Höhe der Nadeln 7 wird die Distanz bezeichnet, um die ihre Spitzen über die Auflagefläche 13 hervorstehen. Ein negativer z-Wert der Höhe bedeutet, dass die Nadeln 7 vollständig in den Löchern 15 versenkt sind und daher nicht über die Auflagefläche 13 hervorstehen.

Das Ablösen und Entnehmen des Halbleiterchips 1 von der Folie 3 wird erfindungsgemäss um eine Vorbereitungsphase erweitert, so dass das ganze Verfahren drei Phasen umfasst. Die erste Phase ist die Vorbereitungsphase, bei der die Klebeverbindung zwischen dem Halbleiterchip 1 und der Folie 3 mit Hilfe der Nadeln 7 geschwächt wird. Bei der ersten Phase ist der Chipgreifer 11 nicht beteiligt. Die zweite Phase ist eine unmittelbar daran anschliessende Phase, bei der der Chipgreifer 11 das weitere Ablösen des Halbleiterchips 1 durch die Nadeln 7 unterstützt. In der dritten Phase wird der Chipgreifer 11 angehoben und weggefahren, wobei sich der Halbleiterchip 1 ohne weitere Unterstützung durch die Nadeln 7 vollständig von der Folie 3 ablöst.

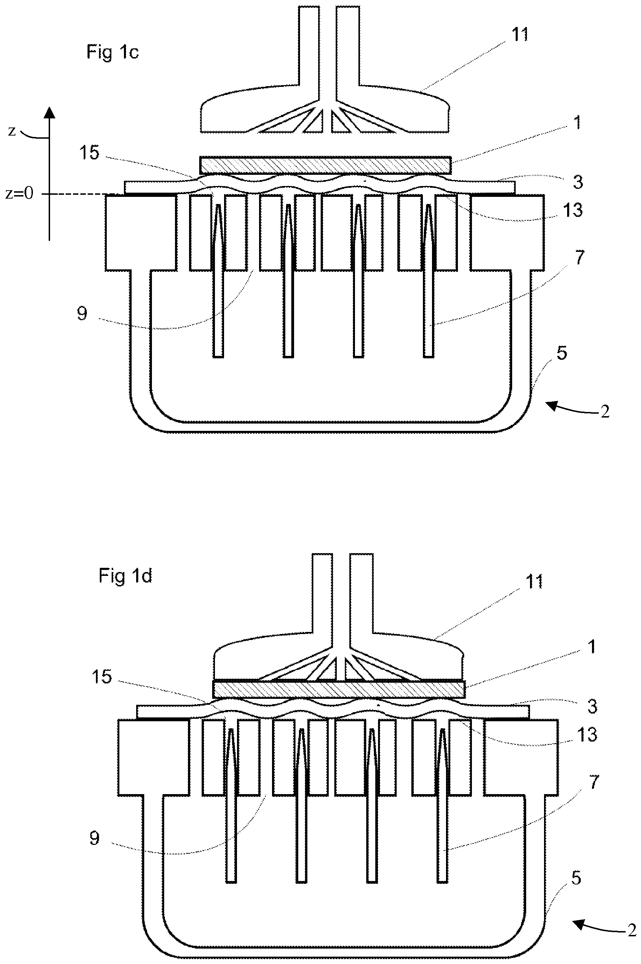

Die erste Phase umfasst die folgenden Schritte:
A) Verschieben des Wafertisches, um den nächsten aufzunehmenden Halbleiterchip 1 oberhalb des Chip-Auswerfers 2 bereitzustellen;
   Die Nadeln 7 befinden sich in einem abgesenkten Zustand innerhalb der Löcher 15, damit sie die Folie 3 während des Schrittes A nicht berühren.
B) Beaufschlagen des Chip-Auswerfers 2 mit Vakuum (bzw. Unterdruck), um die Folie 3 auf dem Chip-Auswerfer 2 festzuhalten;
   Bei diesem Schritt wird die Kammer 5 mit Vakuum beaufschlagt. Das in den Löchern 9 herrschende Vakuum saugt die Folie 3 an. Die Fig. 1a zeigt den Zustand nach diesem Schritt.
C) Anheben der Nadeln 7 auf eine vorbestimmte Höhe z₁.
   Die Höhe z₁ hat einen Wert z₁ > 0, d.h. die Nadeln 7 stehen über die Auflagefläche 13 hervor. Ein typischer Wert von z₁ beträgt 0.5 mm. Bei diesem Schritt werden diejenigen Bereiche der Folie 3, die über den Nadeln 7 liegen, vom Chip-Auswerfer 2 abgehoben. Damit wird auch der Halbleiterchip 1 angehoben, während diejenigen Bereiche der Folie 3, die über den Löchern 9 ohne Nadeln 7 liegen, weiterhin am Chip-Auswerfer 2 bleiben und sich somit vom Halbleiterchip 1 lösen. Dieser Zustand ist in der Fig. 1b dargestellt.
D) Absenken der Nadeln 7 auf eine vorbestimmte Höhe z₂.
   Nach Ablauf einer vorbestimmten Zeitdauer, die typischerweise zwischen 0.5 und 3 Sek. liegt, werden die Nadeln 7 auf eine vorbestimmte Höhe z₂ mit z₂ < z₁ zurückgefahren. Als Folge sind manche Bereiche der Folie 3 noch mit dem Halbleiterchip 1 verklebt, während andere Bereiche bereits vom Halbleiterchip 1 losgelöst sind. Dieser Zustand ist in der Fig. 1c zur Verdeutlichung übertrieben dargestellt, wobei bei diesem Beispiel z₂ < 0 ist. Ob z₂ < 0 oder z₂ = 0 ist, spielt keine Rolle. Ausserdem ist in der Fig. 1c der sich erst jetzt annähernde Chipgreifer 11 gezeigt.

Das Absenken der Nadeln 7 erfolgt, damit eine Kamera die Lage des Halbleiterchips 1 ausmessen kann. Ein Ausmessen bei ausgefahrenen Nadeln 7 ist vielfach problematisch, weil die Chipoberfläche dann zum Teil leicht gewölbt ist und bei senkrecht einfallendem Licht von der Bildverarbeitung zum Teil nicht erkannt wird. Wenn die Nadeln 7 allerdings wieder vollständig in die Löcher 15 zurückgezogen werden, kann das Problem auftreten, dass der Halbleiterchip 1 wieder an der Folie 3 festklebt. Um dies zu vermeiden, ist es vorteilhaft, eine Höhe z₂ > 0 zu wählen, damit sich die Spitzen der Nadeln 7 knapp oberhalb der Auflagefläche 13 befinden, so dass die Kamera den Halbleiterchip 1 noch erkennt und trotzdem der Halbleiterchip 1 nicht wieder an der ganzen Folie 3 festklebt. Vorteilhafte Werte von z₂ liegen im Bereich von 0.0 bis 0.2 mm. Es sei noch erwähnt, dass die Fahrgeschwindigkeit der Nadeln 7 zwischen 1 und 10 mm/s gewählt werden kann.
E) Aufnehmen eines Bildes des Halbleiterchips 1 und Bestimmen seiner Lage bzw. der Abweichung seiner Ist-Lage von seiner Soll-Lage.

Damit ist erste Phase und somit die Vorbereitung zur Entnahme des Halbleiterchips 1 abgeschlossen. Dabei ist es äusserst vorteilhaft, dass für diese vorbereitenden Schritte der Chipgreifer 11 nicht benötigt wird, die Vorbereitung also stattfinden kann, während der Bondkopf selbst noch mit der Verarbeitung (Bondprozess) des zuvor entnommenen Halbleiterchips beschäftigt ist. Entsprechend lange darf diese Vorbereitung dauern, ohne dass sich dabei die Gesamtprozesszeit verlängert. Ausserdem findet dies alles bei Raumtemperatur statt, so dass beim teilweisen Loslösen des Halbleiterchips 1 von der Folie 3 nicht mit Komplikationen wegen erhöhter Temperatur gerechnet werden muss.

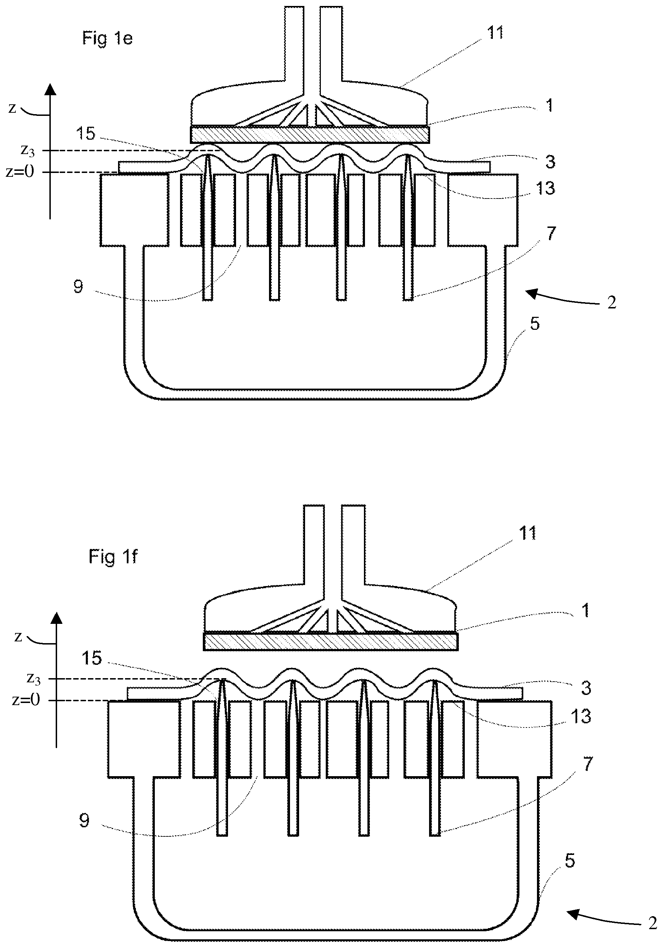

Nun beginnt die zweite Phase mit den Schritten:
F) Absenken des Chipgreifers 11, bis er die Oberfläche des Halbleiterchips 1 berührt, und Beaufschlagen des Chipgreifers 11 mit Vakuum, um den Halbleiterchip 1 festzuhalten;
   Dieser Zustand ist in der Fig. 1d dargestellt.
G) Anheben der Nadeln 7 auf eine vorbestimmte Höhe z₃.
   Bei diesem Schritt heben die Nadeln 7 den Halbleiterchip 1 wieder bzw. weiter an und die Folie 3 löst sich weiter vom Halbleiterchip 1; Ein typischer Wert für z₃ liegt bei 0.5 mm. Der Zustand nach diesem Schritt ist in der Fig. 1e dargestellt. Bei diesem Schritt vergrößern sich die Bereiche, an denen die Folie 3 die Unterseite des Halbleiterchips 1 nicht mehr berührt. (In den Figuren ist dies kaum ersichtlich).

Nun beginnt die dritte Phase mit dem Schritt:
H) Anheben und Wegfahren des Chipgreifers 11.
Bei diesem Schritt löst sich der Halbleiterchip 1 komplett von der Folie 3 sowie von den Nadeln 7 ab.

Da aufgrund der vorbereitenden Schritte A bis C bereits viele Bereiche des Halbleiterchips 1 von der Folie 3 losgelöst wurden, gelingt es nun dem Chipgreifer 11 in Zusammenarbeit mit den Nadeln 7 des Chip-Auswerfers 2 ohne weitere Probleme, den Halbleiterchip 1 mit grosser Geschwindigkeit vollständig von der Folie 3 zu lösen und zu entnehmen. Die Dauer des Chip-Entnahme-Prozesses, d.h. die Zeit, die für die Schritte F bis H benötigt wird (bis der Halbleiterchip 1 nicht mehr in Kontakt mit der Folie 3 ist), wird dadurch von bisher typischerweise 1 Sek., wenn keine Vorbereitung durch die Schritte A bis C der Phase 1 erfolgt, auf 0.1 Sek. reduziert.

Die Fig. 1f zeigt eine Momentaufnahme, wenn sich der Chipgreifer 11 mit dem aufgenommenen Halbleiterchip 1 bereits ein Stück von der Folie 3 entfernt hat. Wie dargestellt, werden die Nadeln 7 erst unter die Auflagefläche 13 heruntergefahren, wenn der Chipgreifer 11 den Halbleiterchip 1 vollständig von der Folie 3 abgelöst hat.

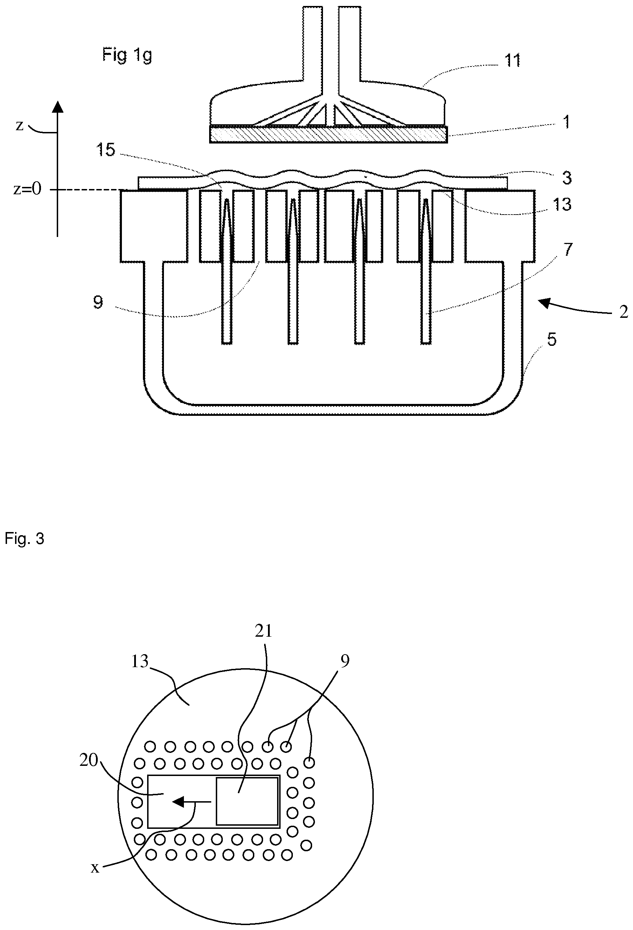

Die Fig. 1g zeigt eine letzte Momentaufnahme, nachdem die Nadeln 7 wieder auf eine Höhe z < 0 abgesenkt wurden, so dass der Pick-Prozess des nächsten Halbleiterchips eingeleitet werden kann. Während der Chipgreifer 11 den soeben entnommenen Halbleiterchip weiter prozessiert, kann bereits mit der ersten Phase für den nächsten zu entnehmenden Halbleiterchip begonnen werden.

Die Entnahme des Halbleiterchips 1 kann anstelle der oben beschriebenen Verfahrensschritte F bis H auch mit anderen Schritten durchgeführt werden, die an die jeweilige Problemstellung angepasst sind und wie sie aus dem Stand der Technik bekannt sind. Im Rahmen der vorliegenden Erfindung ist es allerdings wesentlich, dass der eigentlichen Phase der Chip-Entnahme eine erste, vorbereitende Phase zum zumindest teilweisen Ablösen des Halbleiterchips 1 von der Folie 3 ohne Beteiligung des Chipgreifers 11 und eine zweite Phase zum weiteren Ablösen des Halbleiterchips 1 von der Folie 3 mit Beteiligung des Chipgreifers 11 und weiterer Unterstützung durch die Nadeln 7 des Chip-Auswerfers 2 vorausging.

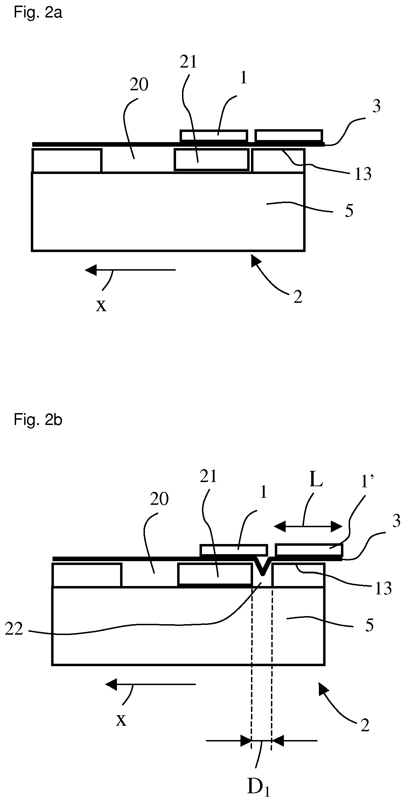

Die Fig. 2a - g zeigen die am Ablösen und Entnehmen eines Halbleiterchips 1 von einer Folie 3 beteiligten Teile eines Montageautomaten zu aufeinanderfolgenden Zeitpunkten während des erfindungsgemässen Pick-Prozesses gemäss einem zweiten Ausführungsbeispiel. Die beteiligten Teile sind vereinfacht und nur insoweit dargestellt, als dies für das Verständnis des Pick-Prozesses nötig ist. Der Chip-Auswerfer 2 umfasst wiederum die mit Vakuum beaufschlagbare Kammer 5 mit dem Deckel mit der Auflagefläche 13, auf der die Folie 3 aufliegt. Die Auflagefläche 13 enthält eine beispielsweise rechteckförmige Öffnung 20 und eine Vielzahl von Löchern 9, die die Öffnung 20 an wenigstens drei Seiten umgeben. In der Öffnung 20 ist ein parallel zur Auflagefläche 13 des Deckels verschiebbarer Schlitten 21 angeordnet. Die Verschiebungsrichtung des Schlittens 21 ist als x-Richtung bezeichnet. In der Verschiebungsrichtung sind: Die Länge des Schlittens etwa so gross wie die Länge des Halbleiterchips 1, die Länge der Öffnung 20 wenigstens doppelt so gross wie die Länge des Halbleiterchips 1. Die Fig. 3 zeigt den Chip-Auswerfer 2 in Aufsicht.

Das Ablösen und Entnehmen des Halbleiterchips 1 von der Folie 3 umfasst wiederum eine erste, vorbereitende Phase, bei der die Klebeverbindung zwischen dem Halbleiterchip 1 und der Folie 3 mit Hilfe des Schlittens 21, aber ohne Beteiligung des Chipgreifers 11, geschwächt wird. Die zweite Phase ist eine unmittelbar daran anschliessende Phase, bei der der Chipgreifer 11 den Halbleiterchip 1 mit Unterstützung des Chip-Auswerfers 2 weiter von der Folie 3 ablöst.

Die erste Phase umfasst die folgenden Schritte:
A) Verschieben des Wafertisches, um den nächsten aufzunehmenden Halbleiterchip 1 oberhalb des Chip-Auswerfers 2 bereitzustellen;
   Der Schlitten 21 wurde vorgängig in der Öffnung 20 so platziert, dass er sich unterhalb des bereitgestellten Halbleiterchips 1 befindet.
B) Beaufschlagen des Chip-Auswerfers 2 mit Vakuum (bzw. Unterdruck), um die Folie 3 auf dem Chip-Auswerfer 2 festzuhalten;
   Das in den Löchern 9 (Fig. 3) herrschende Vakuum saugt die Folie 3 an. Die Fig. 2a zeigt den Zustand nach diesem Schritt. (Der Schlitten 21 befindet sich bei diesem Beispiel beim rechten Rand der Öffnung 20.)
C) Verschieben des Schlittens 21 in der Verschiebungsrichtung um eine vorbestimmte Distanz D₁. (Der Schlitten 21 bewegt sich bei diesem Beispiel nach links.) Der erreichte Zustand ist in der Fig. 2b dargestellt. Die Verschiebung des Schlittens 21 erfolgt mit einer vergleichsweise langsamen Geschwindigkeit, die typischerweise etwa 2-5 mm/s beträgt. Bei diesem Schritt entsteht zwischen der Auflagefläche 13 und dem Schlitten 21 ein Spalt 22 zunehmender Grösse. Das in der Kammer 5 herrschende Vakuum zieht die Folie 3 in den Spalt 22 hinein, wobei sich die Folie 3 in diesem Bereich vom Halbleiterchip 1 ablöst. Die Distanz D₁ beträgt typischerweise etwa 10-20% der Länge L der Halbleiterchips 1, 1'. Dieser Schritt bewirkt, dass die Folie 3 im Bereich einer Kante des Halbleiterchips 1 vom Halbleiterchip 1 abgelöst wird. Dieser Schritt muss sehr sorgfältig erfolgen, weshalb die Geschwindigkeit des Schlittens 21 vergleichsweise klein ist. Dieser Schritt benötigt daher einige Zeit. Ist die Folie jedoch einmal in einem Randbereich von etwa 10-20% der Länge L des Halbleiterchips 1 abgelöst, dann kann sie mit vergleichsweise grosser Geschwindigkeit vom Rest des Halbleiterchips 1 abgezogen werden. Dies erfolgt aber erst in der zweiten Phase, wenn der Chipgreifer 11 das Ablösen unterstützt.
D) Aufnehmen eines Bildes des Halbleiterchips 1 und Bestimmen seiner Lage bzw. der Abweichung seiner Ist-Lage von seiner Soll-Lage.

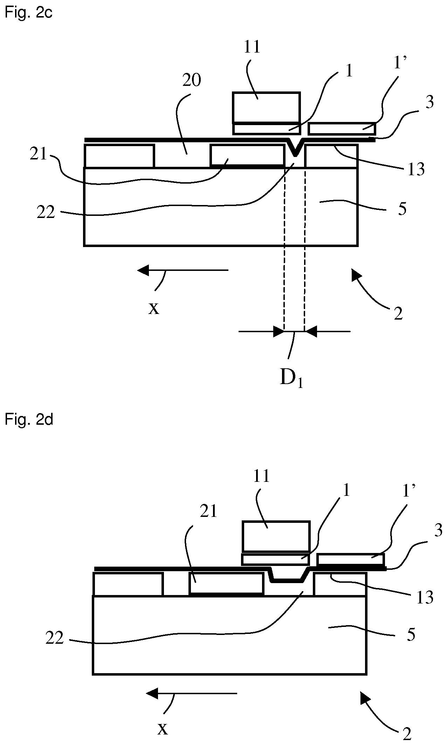

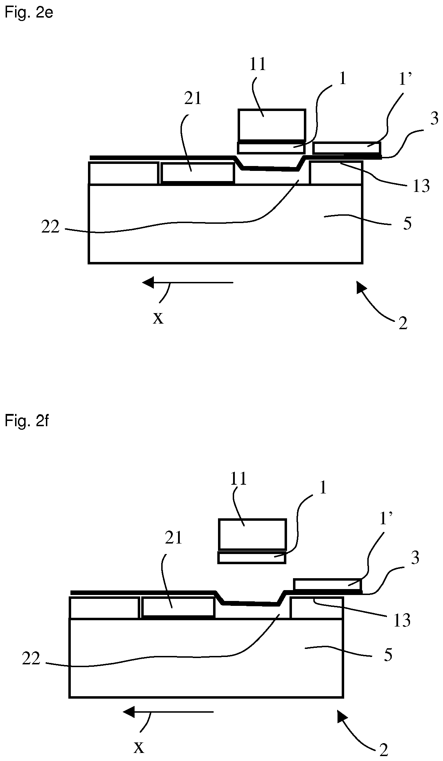

Damit ist die erste Phase und somit die Vorbereitung zur Entnahme des Halbleiterchips 1 abgeschlossen. Nun beginnt die zweite Phase mit den Schritten:
E) Absenken des Chipgreifers 11, bis er die Oberfläche des Halbleiterchips 1 berührt, und
   Beaufschlagen des Chipgreifers 11 mit Vakuum, um den Halbleiterchip 1 festzuhalten; Dieser Zustand ist in der Fig. 2c dargestellt.
F) Weiterverschieben des Schlittens 21 in der gleichen Richtung wie beim Schritt C.
Da die Folie 3 zu Beginn dieses Schrittes bereits von einer Kante des Halbleiterchips 1 abgelöst ist, kann das Verschieben des Schlittens 21 mit vergleichsweise grosser Geschwindigkeit erfolgen. Diese beträgt typischerweise etwa 20 mm/s, ist aber nicht auf diesen Wert beschränkt. Bei diesem Schritt löst sich die Folie 3 wegen des in der Kammer 5 und im Spalt 22 herrschenden Vakuums weiter vom Halbleiterchip 1 ab. Die Fig. 2d zeigt eine Momentaufnahme während dieses Schrittes F, die Fig. 2e zeigt eine Momentaufnahme am Ende des Schrittes F. Der Halbleiterchip 1 ist nun komplett von der Folie 3 abgelöst.

Nun folgt die dritte Phase mit dem Schritt:
G) Anheben und Wegfahren des Chipgreifers 11.
Die Fig. 2f zeigt eine Momentaufnahme während dieses Schrittes.

Das Ablösen des Halbleiterchips 1 von der Folie 3 kann auch mit einer der Vorrichtungen der US 20050059205 vorgenommen werden, wobei der Chipgreifer in der ersten Phase nicht beteiligt ist und wobei der Chip-Auswerfer 2 in der zweiten Phase die Folie 3 weiter vom Halbleiterchip 1 ablöst, während der Halbleiterchip vom Chipgreifer 11 gehalten wird, bevor in der dritten Phase der Chipgreifer 11 angehoben wird und wegfährt, wobei er den Halbleiterchip 1 mitnimmt.

Die beschriebenen erfindungsgemässen Verfahren eignen sich sowohl für Halbleiterchips, deren Rückseite mit einem Klebstofffilm beschichtet ist, als auch für vergleichsweise grosse Halbleiterchips, deren Kantenlängen grösser als 10 mm sind und die mit einem auf das Substrat aufgebrachten Klebstoff mit dem Substrat verklebt werden. Auch in diesem Fall bewirkt die Abschwächung der Klebeverbindung in der ersten Phase eine Verkürzung der Prozesszeit für die Entnahme des Halbleiterchips, da der Chipgreifer nur während einer sehr kurzen Zeit mithelfen muss. Die Ablösung des Halbleiterchips von der Folie kann dank der Erfindung bereits dann erfolgen, wenn der Chipgreifer noch mit dem Bonden des vorausgehenden Halbleiterchips beschäftigt ist.

Die beschriebenen Ausführungsbeispiele enthalten nur die wichtigsten Schritte. Diese Schritte können weitere Unterschritte enthalten oder eventuell innerhalb der entsprechenden Phase in anderer Reihenfolge durchgeführt werden. Der Schritt des Aufnehmens eines Bildes des Halbleiterchips und Bestimmen seiner Lage bzw. der Abweichung seiner Ist-Lage von seiner Soll-Lage kann auch durchgeführt werden, bevor der Halbleiterchip teilweise von der Folie abgelöst wird, nämlich dann, wenn sich seine Lage bei der weiteren Ablösung nicht mehr ändert.

Das teilweise Ablösen des Halbleiterchips von der Folie kann auch mit anderen mechanischen Mitteln erfolgen als den hier beschriebenen.

## Patentansprüche

1. Verfahren zum Ablösen und Entnehmen eines Halbleiterchips (1) von einer Folie (3), bei dem ein Chip-Auswerfer (2) das Ablösen des Halbleiterchips (1) von der Folie (3) unterstützt und ein Chipgreifer (11) den Halbleiterchip (1) aufnimmt, wobei der Chip-Auswerfer (2) eine Auflagefläche (13) aufweist, auf der die Folie (3) aufliegt, umfassend eine erste Phase ohne Beteiligung des Chipgreifers (11), eine nachfolgende zweite Phase und eine nachfolgende dritte Phase, wobei die erste Phase folgende Schritte umfasst:
Bereitstellen des nächsten aufzunehmenden, noch vollständig auf der Folie (3) haftenden Halbleiterchips (1) auf der Auflagefläche (13) des Chip-Auswerfers (2), wo der Halbleiterchip (1) in der zweiten Phase vom Chipgreifer (11) ergriffen werden wird; und dann
Beaufschlagen des Chip-Auswerfers (2) mit Vakuum, um die Folie (3) auf dem Chip-Auswerfer (2) festzuhalten; und dann
Abschwächen der Klebeverbindung zwischen dem Halbleiterchip (1) und der Folie (3) durch teilweises Ablösen der Folie (3) vom bereitgestellten Halbleiterchip (1) mit mechanischen Mitteln, wobei am Ende des Abschwächens der Halbleiterchip (1) von der Folie (3) noch so weit gehalten wird, dass der Halbleiterchip (1) erstens höchstens soweit verbogen oder gekrümmt ist, dass eine Kamera ein auswertbares Bild vom Halbleiterchip (1) aufnehmen kann, und zweitens vom Chipgreifer (11) noch nicht ohne weitere Unterstützung des Chip-Auswerfers (2) von der Folie (3) abgehoben werden kann, ohne dass der Halbleiterchip (1) beschädigt oder zerstört würde, und dann
Aufnehmen eines Bildes des Halbleiterchips (1) und Bestimmen seiner Lage bzw. der Abweichung seiner Ist-Lage von seiner Soll-Lage;
wobei die zweite Phase folgende Schritte umfasst:
Absenken des Chipgreifers (11), bis der Chipgreifer (11) die Oberfläche des Halbleiterchips (1) berührt,
Beaufschlagen des Chipgreifers (11) mit Vakuum, um den Halbleiterchip (1) festzuhalten; und dann
Weiteres Ablösen der Folie (3) vom bereitgestellten Halbleiterchip (1) mit Unterstützung des Chip-Auswerfers (2), wobei am Ende der zweiten Phase die Folie (3) entweder vollständig vom Halbleiterchip (1) abgelöst ist oder den Halbleiterchip (1) nur noch auf einem kleinen Anteil der Fläche der Unterseite berührt; und wobei die dritte Phase den Schritt umfasst:
Anheben und Wegfahren des Chipgreifers (11) von der Folie (3).

2. Verfahren nach Anspruch 1, bei dem das besagte teilweise Ablösen des Halbleiterchips (1) von der Folie (3) durch Verschieben eines Schlittens (21) erfolgt, so dass sich in der Auflagefläche (13) des Chip-Auswerfers (2) unterhalb einer Kante des bereitgestellten Halbleiterchips (1) ein Spalt (22) bildet, wobei das im Spalt (22) herrschende Vakuum die Folie (3) in den Spalt (22) zieht und vom Halbleiterchip (1) ablöst, wobei die Breite des Spalts (22) am Ende der ersten Phase etwa 10-20% der Länge der Halbleiterchips (1) beträgt.

3. Verfahren nach Anspruch 1, bei dem das Ablösen des Halbleiterchips (1) von der Folie (3) mit Nadeln (7) unterstützt wird, die senkrecht oder schräg zur Auflagefläche (13) verschiebbar sind, und wobei eine Distanz, um die die Spitzen der Nadeln (7) über die Auflagefläche (13) hinausragen, als Höhe bezeichnet wird, bei dem das besagte teilweise Ablösen der Folie (3) vom bereitgestellten Halbleiterchip (1) erfolgt durch die Schritte:
Anheben der Nadeln (7) auf eine vorbestimmte Höhe z₁, so dass die Nadeln (7) über die Auflagefläche (13) hinausragen; und
Absenken der Nadeln (7) auf eine vorbestimmte Höhe z₂, die kleiner ist als die Höhe z₁.

4. Verfahren nach Anspruch 3, **dadurch gekennzeichnet, dass** die Höhe z₂ so gewählt ist, dass die Nadeln (7) nicht über die Auflagefläche (13) hinausragen.

## Claims

1. Method for detaching and removing a semiconductor chip (1) from a foil (3), in which a chip ejector (2) supports the detachment of the semiconductor chip (1) from the foil (3) and a chip gripper (11) takes up the semiconductor chip (1), with the chip ejector (2) having a support surface (13) on which the foil (3) rests, the method comprising a first phase without any participation of the chip gripper (11), a subsequent second phase and a subsequent third phase, the first phase comprising the steps:
providing the next semiconductor chip (1) to be removed on the support surface (13) of the chip ejector (2), where the semiconductor (1) chip will be grasped by the chip gripper (11) in the second phase, the semiconductor chip (1) still completely adhering to the foil (3); and then
supplying a vacuum to the chip ejector (2) in order to tightly hold the foil (3) on the chip ejector (2); and then
weakening of an adhesive bond between the semiconductor chip (1) and the foil (3) by partially detaching the foil (3) from the provided semiconductor chip (1) with mechanical means, wherein at the end of this weakening, the semiconductor chip (1) is held by the foil (3) to such an extent that firstly the semiconductor chip (1) is bent or curved at most to the extent that a camera is able to take a picture of the semiconductor chip (1) that can be evaluated and that secondly without further support by the chip ejector (2) the semiconductor chip (1) cannot yet be lifted by the chip gripper (11) from the foil (3) without damaging or destroying the semiconductor chip (1), and then
taking a picture of the semiconductor chip (1) and determining its position or deviation of its actual position from its target position, respectively;
the second phase comprising the following steps:
lowering the chip gripper (11) until the chip gripper (11) touches the surface of the semiconductor chip (1);
supplying a vacuum to the chip gripper (11) in order to tightly hold the semiconductor chip (1); and then
further detaching the foil (3) from the provided semiconductor chip (1) with support by the chip ejector (2), wherein at the end of the second phase, the foil is either completely detached from the semiconductor chip (1) or the foil (3) touches the semiconductor chip (1) only on a small portion of the underside;
and the third phase comprising the step:
lifting and moving the chip gripper (11) away from the foil (3).

2. Method according to claim 1, wherein said partially detaching of the semiconductor chip (1) from the foil (3) occurs by displacement of a carriage (21), so that a gap (22) is formed in the support surface (13) of the chip ejector (2) beneath an edge of the provided semiconductor chip (1), with the vacuum prevailing in the gap (22) drawing the foil (3) into the gap (22) and detaching the same from the semiconductor chip (1), wherein at the end of the first phase the width of the gap (22) amounts to approximately 10% to 20% of the length of the semiconductor chip (1).

3. Method according to claim 1, wherein the detachment of the semiconductor chip (1) from the foil (3) is supported with needles (7) which are displaceable in a perpendicular or oblique direction in relation to the support surface (13), and with a distance by which the tips of the needles (7) protrude beyond the support surface (13) being designated as height, wherein said partially detaching of the foil (3) from the provided semiconductor chip (1) occurs by the steps:
lifting the needles (7) to a predetermined height z₁, so that the needles (7) protrude beyond the support surface (13), and
lowering the needles (7) to a predetermined height z₂ which is smaller than the height z₁.

4. Method according to claim 3, **characterized in that** the height z₂ is chosen in such a way that the needles (7) do not protrude beyond the support surface (13).

## Revendications

1. Procédé pour décoller et retirer une puce de semi-conducteurs (1) d'un film (3), dans lequel un éjecteur de puce (2) facilite le décollement de la puce de semi-conducteurs (1) du film (3) et un organe de préhension de la puce (11) récupère la puce de semi-conducteurs (1), dans lequel l'éjecteur de puce (2) présente une surface d'appui (13) sur laquelle repose le film (3), comprenant une première phase sans participation de l'organe de préhension de la puce (11), puis une deuxième phase et une troisième phase, la première phase comprenant les étapes suivantes:
présentation de la prochaine puce de semi-conducteurs (1), adhérant encore complètement au film (3), sur la surface d'appui (13) de l'éjecteur de puce (2), où la puce de semi-conducteurs (1) est saisie dans la deuxième phase par l'organe de préhension de la puce (11); puis
application d'un vide à l'éjecteur de puce (2) pour retenir le film (3) sur l'éjecteur de puce (2); puis
affaiblissement du collage entre la puce de semi-conducteurs (1) et le film (3) par le décollement partiel du film (3) de la puce de semi-conducteurs (1) présentée avec des moyens mécaniques, la puce de semi-conducteurs (1) étant encore retenue par le film (3) à la fin de l'affaiblissement pour que la puce de semi-conducteurs (1) soit d'une part courbée ou pliée au maximum, suffisamment pour qu'une caméra puisse acquérir une image exploitable de la puce de semi-conducteurs (1), et d'autre part qu'elle ne puisse pas encore être soulevée du film (3) par l'organe de préhension de la puce (11) sans l'assistance de l'éjecteur de puce (2) sans endommager ou détruire la puce de semi-conducteurs (1); puis
acquisition d'une image de la puce de semi-conducteurs (1) et détermination de sa position ou de l'écart entre sa position réelle et sa position de consigne;
la deuxième phase comprenant les étapes suivantes:
abaissement de l'organe de préhension de la puce (11) jusqu'à ce que l'organe de préhension de la puce (11) touche la surface de la puce de semi-conducteurs (1), application d'un vide à l'organe de préhension de la puce (11) pour retenir la puce de semi-conducteurs (1); puis
poursuite du décollement du film (3) de la puce de semi-conducteurs (1) présentée avec l'assistance de l'éjecteur de puce (2), le film (3) étant entièrement décollé de la puce de semi-conducteurs (1) ou la puce de semi-conducteurs (1) ne touchant plus qu'une petite partie de la surface de la face inférieure à la fin de la deuxième phase;
et la troisième phase comprenant l'étape suivante:
soulèvement et éloignement de l'organe de préhension de la puce (11) du film (3).

2. Procédé selon la revendication 1, dans lequel ledit décollement partiel de la puce de semi-conducteurs (1) du film (3) est réalisé par la translation d'un chariot (21), de sorte qu'il se forme une fente (22) dans la surface d'appui (13) de l'éjecteur de puce (2) en dessous d'un bord de la puce de semi-conducteurs (1) présenté, le vide qui règne dans la fente (22) aspirant le film (3) dans la fente (22) et le décollant de la puce de semi-conducteurs (1), la largeur de la fente (22) à la fin de la première phase représentant environ 10 % à 20 % de la longueur de la puce de semi-conducteurs (1).

3. Procédé selon la revendication 1, dans lequel le décollement de la puce de semi-conducteurs (1) du film (3) est assisté par des aiguilles (7) qui peuvent être déplacées perpendiculairement ou en oblique par rapport à la surface d'appui (13), et dans lequel une distance de laquelle les pointes des aiguilles (7) dépassent de la surface d'appui (13) est désignée comme la hauteur à laquelle ledit décollement partiel du film (3) de la puce de semi-conducteurs (1) présentée se produit par les étapes suivantes:
soulèvement des aiguilles (7) jusqu'à une hauteur z₁ prédéterminée, de telle sorte que les aiguilles (7) dépassent de la surface d'appui (13); et
abaissement des aiguilles (7) à une hauteur z₂ prédéterminée qui est inférieure à la hauteur z₁.

4. Procédé selon la revendication 3, **caractérisé en ce que** la hauteur z₂ est choisie de telle manière que les aiguilles (7) ne dépassent pas de la surface d'appui (13).
